# EUROPÄISCHE PATENTSCHRIFT

(11) **EP 1 166 274 B1**
(45) Veröffentlichungstag und Bekanntmachung des Hinweises auf die Patenterteilung: **11.12.2002**
(21) Anmeldenummer: 00920382.9
(22) Anmeldetag: 13.03.2000
(51) Int. Cl.: G11C 11/16, G11C 7/14

(54) **VORRICHTUNG ZUR BEWERTUNG DER ZELLENWIDERSTÄNDE IN EINEM MAGNETORESISTIVEN SPEICHER**
DEVICE FOR WEIGHTING THE CELL RESISTANCES IN A MAGNETORESISTIVE MEMORY
DISPOSITIF POUR PONDERER LES RESISTANCES DE CELLULES D'UNE MEMOIRE MAGNETORESISTIVE

(30) Priorität: 30.03.1999 DE 19914489
(43) Veröffentlichungstag der Anmeldung: 02.01.2002
(73) Patentinhaber: Infineon Technologies AG, 81669 München (DE)
(72) Erfinder: THEWES, Roland, D-82194 Gröbenzell (DE); WEBER, Werner, D-80637 München (DE)
(74) Vertreter: Ginzel, Christian
(86) Internationale Anmeldenummer: DE0000776
(87) Internationale Veröffentlichungsnummer: WO00060600

(56) Entgegenhaltungen:
- EP-A- 0 383 078
- US-A- 5 173 873
- US-A- 5 493 533
- HIROTO NAKAI ET AL: "A 36NS 1MBIT CMOS EPROM WITH NEW DATA SENSING TECHNIQUE" SYMPOSIUM ON VLSI CIRCUITS,US,NEW YORK, IEEE, vol. SYMP. 4, 7 June 1990 (1990-06-07), pages 95-96, XP000145623

## Beschreibung

Die Erfindung betrifft eine Vorrichtung zur Bewertung eines magnetisch veränderbaren elektrischen Widerstands einer magnetoresistiven Speicherzelle mit Hilfe einer Referenzzelle. Eine solche Speicherzelle weist typischerweise eine weichmagnetische Schicht und eine hartmagnetische Schicht auf, die elektrisch leitend und durch ein Tunneloxid voneinander getrennt sind, wobei die Tunnelwahrscheinlichkeit und damit der elektrische Widerstand von den Polarisierungsrichtungen der beiden Schichten abhängt.

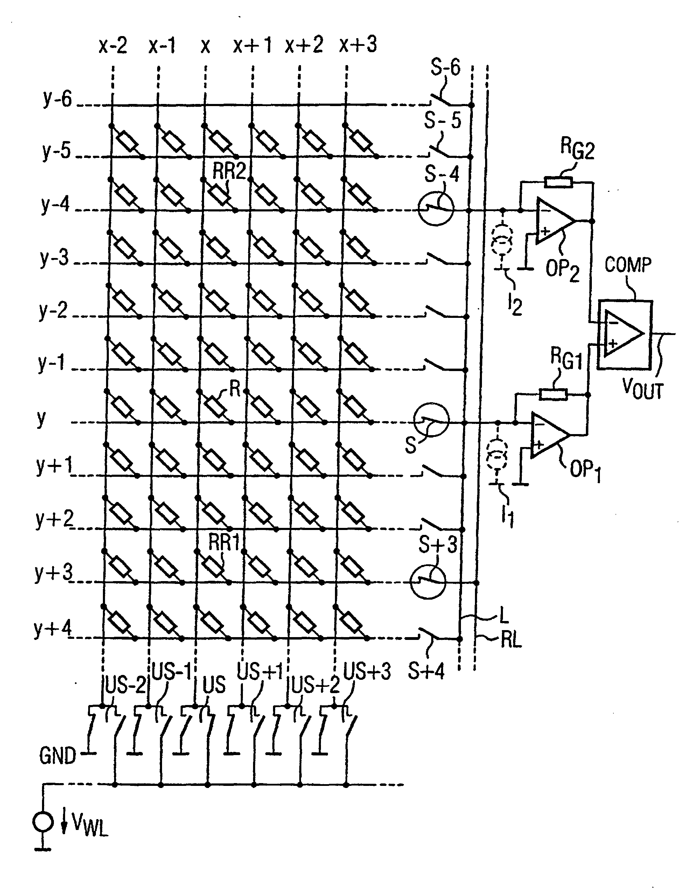

Eine solche Vorrichtung ist aus dem US-Patent 5,173,873, insbesondere aus Figur 4, bekannt, wobei jeweils pro Spalte nur eine einzige Referenzzelle zur Bewertung einer Speicherzelle herangezogen wird und eine Bewertung hierdurch schnell und mit geringer Verlustleistung erfolgt.

Aufgrund der Fertigungstoleranzen sind die Zellenwiderstände über das gesamte Speicherzellenfeld nicht konstant und es treten, insbesondere bei großen Speicherzellenfeldern, leicht Fehlbewertungen auf, weil die relative Widerstandsänderung einer Speicherzelle aufgrund einer Änderung der gespeicherten Information nur gering ist.

Die US 5 493 533 A beschreibt einen nichtflüchtigen Speicher mit alternierend angeordneten spalten von regularen Zellen und Referenzzellen.

Die der Erfindung zugrundeliegende Aufgabe besteht nun darin, eine Vorrichtung zur Bewertung der Zellenwiderstände in einem magnetoresistiven Speicher (MRAM) anzugeben, bei der mit möglichst geringem Zusatzaufwand, insbesondere bei großen MRAMs, eine möglichst hohe Bewertungssicherheit erreicht wird.

Diese Aufgabe wird erfindungsgemäß durch die Merkmale des Patentanspruchs 1 gelöst. Eine vorteilhafte Ausbildung der Erfindung ergibt sich aus dem Unteranspruch 2.

Die Erfindung besteht im wesentlichen darin, daß in einem Zellenfeld, beispielsweise in regelmäßigen Abständen, Zeilen mit Referenzzellen vorgesehen werden und ein jeweiliger Zellenwiderstand mit einem Mittelwert aus jeweils den beiden nächstgelegenen Referenzzellenwiderständen verglichen wird, wobei jeweils ein Referenzzellenwiderstand für zwei Gruppen von Zellenwiderständen zum Vergleich herangezogen wird.

Nachfolgend wird ein bevorzugtes Ausführungsbeispiel der Erfindung anhand der Zeichnung näher erläutert. Die Zeichnung zeigt eine matrizenförmige Anordnung von Bitleitungen y + 4 ... y.... y - 6 und Wortleitungen x - 2 ... x ... x +3, die einen Ausschnitt aus einem Zellenfeld eines magnetoresistiven Speichers darstellt. Zwischen jeder Bitleitung und jeder Wortleitung ist ein Widerstand einer magnetoresistiven Speicherzelle vorhanden, der üblicherweise aus einem übereinanderliegenden und durch ein Tunneloxid getrennten weichmagnetischen und einem hartmagnetischen Bereich besteht. In dem dargestellten Zellenfeld bilden, beispielsweise alle mit der Bitleitung y + 3 verbundenen Zellwiderstände und alle mit der Bitleitung y - 4 verbundenen Zellwiderstände, im Vergleich zu den übrigen Zellwiderständen, hier dicker gezeichnet, Referenzzellwiderstände. Zwischen einer ausgewählten Wortleitung x und einer ausgewählten Bitleitung y liegt ein Zellwiderstand R und zwischen derselben Wortleitung und den beiden nächstgelegenen Referenzbitleitungen y + 3 und y - 4 liegen die Referenzzellwiderstände RR1 und RR2. Die Auswahl bzw. die Adressierung der Wortleitungen erfolgt hier mit Hilfe von Umschaltern US - 2 ... US + 3, die der Reihe nach mit den Wortleitungen x - 2 ... x + 3 verbunden sind und über die jeweils eine Wortleitung, hier die Wortleitung x, mit einer Wortleitungsspannung V_{WL} und die anderen Wortleitungen mit Bezugspotential GND beaufschlagt werden. Die Referenzbitleitungen, beispielsweise y + 3 und y - 4, werden über Schalter, beispielsweise S - 4 und S + 3, auf eine gemeinsame Referenzleitung RL durchgeschaltet, da sie dem adressierten Zellenwiderstand R am nächsten liegen. Die ausgewählte Bitleitung y wird mit dem Schalter S auf eine gemeinsame Leitung L geschaltet. Damit nicht alle mit der Wortleitung x verbundenen Zellwiderstände, sondern nur der mit der adressierten Bitleitung verbundene Zellwiderstand R auf eine gemeinsame Leitung L durchgeschaltet wird, bleiben alle weiteren mit regulären Bitleitungen und der gemeinsamen Leitung L verbundenen Schalter, beispielsweise S - 6 und S - 5, geöffnet. Die Referenzzellwiderstände RR1 und RR2 bilden zusammen mit einem über einen Widerstand R_{G2} rückgekoppelten Operationsverstärker OP₂, einen invertierenden Summationsverstärker, der an seinem Ausgang eine Spannung liefert, die vom Mittelwert aus den beiden Zellenwiderständen RR1 und RR2 abhängt. Der Zellenwiderstand R bildet zusammen mit einem über einen Widerstand R_{G1} rückgekoppelten Operationsverstärker OP₁, ebenfalls einen invertierenden Spannungsverstärker, wobei der Rückkoppelwiderstand R_{G1} den zweifachen Wert des Rückkopplungswiderstandes R_{G2} des Operationsverstärkers OP₂ aufweist. Damit ein mit dem Referenzsignal des Summationsverstärkers vergleichbares Signal entsteht, da ja über die beiden Referenzzellwiderstände der doppelte Strom geliefert wird als durch den einzelnen Widerstand R. Die Ausgangsspannung des invertierenden Summationsverstärkers OP₂ wird dem invertierenden Eingang und die Ausgangsspannung des invertierenden Verstärkers OP₁ wird dem nicht invertierenden Eingang eines Komparators COMP zugeführt, an dessen Ausgang ein vom jeweiligen Zellenwiderstand abhängiges Bewertungssignal V_{OUT} ansteht. Durch diese Beschaltung kann vorteilhafterweise ein gewöhnlicher Komparator verwendet werden.

Das Verhältnis der Anzahl zwischen regulären Bitleitungen und Referenzbitleitungen ist entsprechend den Parameterschwankungen und der relativen Widerstandsänderung zu wählen, damit keine Fehlbewertung auftritt. Hier in diesem Beispiel stellt jede achte Bitleitung eine Referenzbitleitung dar.

In einer vorteilhaften Ausgestaltung des obigen Ausführungsbeispiels ist zusätzlich eine erste Stromsenke I₂ und eine weitere Stromsenke I₁ vorhanden, wobei der eine Verbindungsknoten zwischen dem jeweiligen Referenzzellwiderstand und einem Rückkoppelwiderstand R_{G2} des Summationsverstärkers über die erste Stromsenke I₂ mit Bezugspotential GND sowie ein Verbindungsknoten zwischen dem jeweiligen adressierten Zellenwiderstand R und einem weiteren Rückkoppelwiderstand R_{G1} des Verstärkers mit der doppelten Verstärkung über die weitere Stromsenke I₁ mit Bezugspotential verbunden sind, wobei die Stromsenke I₂ den doppelten Strom der weiteren Stromsenke I₁ aufweist. Diese Maßnahme dient dazu, beide Operationsverstärker OP₁ und OP₂ während des Bewertungsvorgangs in einem günstigem Arbeitspunkt, d. h. mit geringer DC-Offset-Ausgangsspannung, zu betreiben. Dafür muß die Bedingung I₁=V_{WL}/R eingehalten werden, wobei über den Widerstand R und die Stromquelle I₁ bzw. über die Referenzwiderstände RR1 und RR2 und die Stromquelle I₂ jeweils Ströme mit entgegengesetztem Vorzeichen in die entsprechenden gemeinsamen Knoten eingespeist werden müssen.

## Patentansprüche

1. Magnetoresistiver Speicher mit einer Vorrichtung zur Bewertung der Zellenwiderstände,
bei dem in einem Zellehfeld eine Vielzahl von Speicherzellen mit einem Zellenwiderstand (R) und eine Vielzahl von Referenzzellen mit einem Referenzzellenwiderstand (RR1, RR2) vorgesehen sind,
bei dem neben einem ausgewählten Zellenwiderstand (R) gleichzeitig jeweils zwei nächstgelegene Referenzzellwiderstände (RR1, RR2) mit einer gemeinsamen Wortleitungsspannung (V_{WL}) verbindbar sind,
bei dem eine ausgewählte Bitleitung (y) über den ausgewählten Zellenwiderstand (R) und entsprechend gleichzeitig zwei nächstgelegene Referenzbitleitungen (y + 3, y - 4) über die Referenzzellwiderstände (RR1, RR2) mit der Wortleitungsspannung (V_{WL}) verbindbar sind,
bei dem die Referenzzellwiderstände zusammen mit einem rückgekoppelten Verstärker (OP₂, RG₂) einen Summationsverstärker bilden,
bei dem der jeweilige Zellwiderstand zusammen mit einem wieteren rückgekoppelten Verstärker (OP₁, RG₁) einen Verstärker mit der gleichen Verstärkung des Summationsverstärkers bilden und
bei dem der Ausgang des Summationsverstärkers und der Ausgang des weiteren Verstärkers jeweils mit einem Eingang eines Komparators verbunden sind, dessen Ausgang ein vom jeweiligen Zellenwiderstand abhängiges Bewertungssignal (V_{OUT}) liefert.

2. Speicher nach Anspruch1,
bei dem ein Verbindungsknoten zwischen dem jeweiligen Referenzzellwiderstand und einem Rückkoppelwiderstand (R_{G2}) des Summationsverstärkers über eine erste Stromsenke (I₂) mit Bezugspotential (GND) verbunden ist und bei dem ein Verbindungsknoten zwischen dem jeweiligen Zellenwiderstand (R) und einem weiteren Rückkoppelwiderstand (R_{G1}) des Verstärkers mit der doppelten Verstärkung über eine weitere Stromsenke (I₁) mit Bezugspotential verbunden ist, wobei die Stromsenke (I₂) den doppelten Strom der weiteren Stromsenke (I₁) aufweist und der Strom der weiteren Stromsenke dem Betrag der Wortleitungsspannung (V_{WL}) geteilt durch den Betrag des Zellwiderstands (R) entspricht.

## Claims

1. Magnetoresistive memory having a device for evaluating the cell resistances,
in which a multiplicity of memory cells having a cell resistor (R) and a multiplicity of reference cells having a reference cell resistor (RR1, RR2) are provided in a cell array,
in which, in addition to a selected cell resistor (R), in each case two nearest reference cell resistors (RR1, RR2) can be simultaneously connected to a common word line voltage (V_{WL}),
in which a selected bit line (y) can be connected to the word line voltage (V_{WL}) via the selected cell resistor (R) and correspondingly at the same time two nearest reference bit lines (y + 3, y - 4) can be connected to the word line voltage (V_{WL}) via the reference cell resistors (RR1, RR2),
in which the reference cell resistors together with a feedback amplifier (OP₂, RG₂) form a summing amplifier,
in which the respective cell resistor together with a further feedback amplifier (OP₁, RG₁) form an amplifier having the same gain as the summing amplifier, and
in which the output of the summing amplifier and the output of the further amplifier are in each case connected to an input of a comparator whose output supplies an evaluation signal (V_{OUT}) dependent on the respective cell resistor.

2. Memory according to Claim 1,
in which a connecting node between the respective reference cell resistor and a feedback resistor (R_{G2}) of the summing amplifier is connected to reference-earth potential (GND) via a first current sink (I₂), and in which a connecting node between the respective cell resistor (R) and a further feedback resistor (R_{G1}) of the amplifier having twice the gain is connected to reference-earth potential via a further current sink (I₁), the current sink (I₂) having twice the current of the further current sink (I₁) and the current of the further current sink corresponding to the magnitude of the word line voltage (V_{WL}) divided by the magnitude of the cell resistor (R).

## Revendications

1. Mémoire magnétorésistive ayant un dispositif de pondération des résistances des cellules,
dans laquelle il est prévu, dans un champ de cellules, une pluralité de cellules de mémoire ayant une résistance (R) de cellule et une pluralité de cellules de référence ayant une résistance (RR1, RR2) de cellule de référence,
dans laquelle il peut être appliqué une tension (V_{WL}) commune de lignes de mots outre à une résistance (R) de cellule qui peut être sélectionnée en même temps respectivement à deux résistances (RR1, RR2) de cellules de référence les plus proches,
dans laquelle il peut être appliqué la tension (V_{WL}) de lignes de mots à une ligne (y) de bits sélectionnée par l'intermédiaire de la résistance (R) de cellule sélectionnée et, d'une manière correspondante, en même temps à deux lignes (y + 3, y - 4) de bits de référence les plus proches par l'intermédiaire des résistances (RR, RR2) de cellules de référence,
dans laquelle les résistances de cellules de référence forment ensemble avec un amplificateur (OP₂, RG₂) à réaction un amplificateur de sommation,
dans laquelle la résistance respective de cellule forme ensemble avec un autre amplificateur (OP₁, RG₁) à réaction un amplificateur ayant le même gain que l'amplificateur de sommation et
dans laquelle la sortie d'amplificateur de sommation et la sortie de l'autre amplificateur sont reliées respectivement à une entrée d'un comparateur dont la sortie fournit un signal (V_{OUT}) de pondération qui dépend de la résistance respective de cellule.

2. Mémoire suivant la revendication 1,
dans laquelle un noeud de liaison entre la résistance respective de cellule de référence et une résistance (RG₂) de réaction de l'amplificateur de sommation est relié à un potentiel (GND) de référence par l'intermédiaire d'un premier puits (I₂) de courant et dans laquelle un noeud de liaison entre la résistance (R) respective de cellule et une autre résistance (R_{G1}) de réaction de l'amplificateur à gain double est relié au potentiel de référence par l'intermédiaire d'un autre puits (I₁) de courant, le puits (I₂) de courant ayant le courant double de l'autre puits (I₁) de courant et le courant de l'autre puits de courant correspondant à la valeur absolue de la tension (V_{WL}) de la ligne de mots divisée par la valeur absolue de la résistance (R) de cellule.
